(19) Europäisches Patentamt
European Patent Office
Office européen des brevets

(11) **EP 2 308 143 B1**

(12) **EUROPÄISCHE PATENTSCHRIFT**

(45) Veröffentlichungstag und Bekanntmachung des Hinweises auf die Patenterteilung:
**26.10.2016 Patentblatt 2016/43**

(51) Int Cl.:
**H01S 5/34** *(2006.01)* **B82Y 20/00** *(2011.01)*
**H01S 5/10** *(2006.01)* **H01S 5/32** *(2006.01)*
**H01S 5/183** *(2006.01)*

(21) Anmeldenummer: **09775999.7**

(22) Anmeldetag: **20.07.2009**

(86) Internationale Anmeldenummer:
**PCT/DE2009/001025**

(87) Internationale Veröffentlichungsnummer:
**WO 2010/012268 (04.02.2010 Gazette 2010/05)**

(54) **PHOTONENPAARQUELLE UND VERFAHREN ZU DEREN HERSTELLUNG**

PHOTON PAIR SOURCE AND METHOD FOR ITS PRODUCTION

SOURCE DE PAIRES DE PHOTONS ET SON PROCÉDÉ DE PRODUCTION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **01.08.2008 DE 102008036400**

(43) Veröffentlichungstag der Anmeldung:
**13.04.2011 Patentblatt 2011/15**

(73) Patentinhaber: **Technische Universität Berlin 10623 Berlin (DE)**

(72) Erfinder:
• **WINKELNKEMPER, Momme**
**10967 Berlin (DE)**
• **SCHLIWA, Andrei**
**15859 Storkow (DE)**
• **BIMBERG, Dieter**
**14089 Berlin (DE)**

(74) Vertreter: **Fischer, Uwe Patentanwalt Moritzstraße 22 13597 Berlin (DE)**

(56) Entgegenhaltungen:
• **GALLO P ET AL: "Integration of site-controlled pyramidal quantum dots and photonic crystal membrane cavities" APPLIED PHYSICS LETTERS, AIP, AMERICAN INSTITUTE OF PHYSICS, MELVILLE, NY, US, Bd. 92, Nr. 26, 30. Juni 2008 (2008-06-30), Seiten 263101-263101, XP012107800 ISSN: 0003-6951**
• **Prof. Eli Kapon: "Ordered Pyramidal Quantum Dots for Quantum Photonics Applications" Ecole Polytechnique Fédérale de Lausanne (EPF) - Suisse NCCR QP Projects: Phase 2 4. Februar 2006 (2006-02-04), XP002566711 Gefunden im Internet: URL:http://nccr-qp.epfl.ch/webdav/site/nccr/shared/Projects%20pdf/2.B.pdf> [gefunden am 2010-02-03]**
• **BIMBERG D ET AL: "Quantum Dots for Single-and Entangled-Photon Emitters" IEEE PHOTONICS JOURNAL, IEEE, USA, Bd. 1, Nr. 1, 1. Juni 2009 (2009-06-01), Seiten 58-68, XP011269618 ISSN: 1943-0655**
• **MOHAN A ET AL: "Entangled photons produced with high-symmetry site-controlled quantum dots" INDIUM PHOSPHIDE&RELATED MATERIALS, 2009. IPRM '09. IEEE INTERNATIONAL CONFERENCE ON, IEEE, PISCATAWAY, NJ, USA, 10. Mai 2009 (2009-05-10), Seiten 410-411, XP031467254 ISBN: 978-1-4244-3432-9**
• **STEVENSON R M ET AL: "A semiconductor source of triggered entangled photon pairs" NATURE NATURE PUBLISHING GROUP UK, Bd. 439, Nr. 7073, 12. Januar 2006 (2006-01-12), Seiten 179-182, XP002566712 ISSN: 0028-0836**

**(Forts. nächste Seite)**

- SUGIYAMA Y ET AL: "Novel InGaAs/GaAs quantum dot structures formed in tetrahedral-shaped recesses on (111)B GaAs substrate using metalorganic vapor phase epitaxy" APPLIED PHYSICS LETTERS, AIP, AMERICAN INSTITUTE OF PHYSICS, MELVILLE, NY, US, Bd. 67, Nr. 2, 10. Juli 1995 (1995-07-10), Seiten 256-258, XP012014016 ISSN: 0003-6951

- SANTORI C ET AL: "Polarization-correlated photon pairs from a single quantum dot" PHYSICAL REVIEW B (CONDENSED MATTER AND MATERIALS PHYSICS) APS THROUGH AIP USA, Bd. 66, Nr. 4, 15. Juli 2002 (2002-07-15), Seiten 045308/1-4, XP002566713 ISSN: 0163-1829

**Beschreibung**

Photonenpaarquelle und Verfahren zu deren Herstellung Die Erfindung bezieht sich auf ein Verfahren mit den Merkmalen gemäß dem Oberbegriff des Anspruchs 1.

Ein derartiges Verfahren ist aus der Internationalen Patentanmeldung WO 2007/062625 A2 bekannt. Bei diesem vorbekannten Verfahren wird eine verschränkte Photonenpaare erzeugende Photonenpaarquelle hergestellt, indem ein oder mehrere Quantenpunkte auf einem Substrat abgeschieden werden. Um zu erreichen, dass die Photonenpaarquelle verschränkte Photonenpaare erzeugen kann, wird die Feinstrukturaufspaltung des exzitonischen Energieniveaus des bzw. der Quantenpunkte möglichst klein eingestellt. In der genannten Druckschrift wird empfohlen, für die Feinstrukturaufspaltung einen Bereich zwischen -100 $\mu$eV und +100 $\mu$eV vorzusehen, um die Erzeugung verschränkter Photonenpaare zu ermöglichen. Erreicht wird eine solche Feinstrukturaufspaltung gemäß der Lehre der Druckschrift dadurch, dass eine Atomanzahl pro Quantenpunkt zwischen 800 und 5000 Atomen eingestellt wird.

Weitere Verfahren zur Herstellung von derartigen Photonenpaarquellen sind in "Integration of site-controlled pyramidal quantum dots and photonic crystal membrane cavities" von P. Gallo & al., Applied Physics Letters 92, 263101 (2008) und "A semiconductor source of triggered entangled photon pairs" von R.M.Stevenson & al., Nature, Vol. 439, 12.01.2006. Seiten 179-182, offenbart.

Der Erfindung liegt die Aufgabe zugrunde, ein Verfahren zum Herstellen einer verschränkte Photonenpaare erzeugenden Photonenpaarquelle anzugeben, das sich noch einfacher und reproduzierbarer als bisherige Verfahren durchführen lässt.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass das Einstellen der Feinstrukturaufspaltung des exzitonischen Energieniveaus der Quantenpunkte dadurch erfolgt, dass diese auf einer {111}-Kristallfläche eines Halbleitersubstrats abgeschieden werden. Unter einer {111}-Kristallfläche werden die (111)-orientierte Kristallfläche des Substrats sowie alle anderen Kristallflächen verstanden, die zu der (111)-orientierten Kristallfläche äquivalent sind.

Ein wesentlicher Vorteil des erfindungsgemäßen Verfahrens ist darin zu sehen, dass bei diesem die Feinstrukturaufspaltung stets Null, zumindest stets nahezu Null, ist. Dieser Sachverhalt wurde erfinderseitig durch theoretische Untersuchungen festgestellt, bei denen die exzitonischen Zustände der Quantenpunkte mittels der so genannten Konfigurations-Wechselwirkungsmethode (nachfolgend kurz CI-Methode genannt) berechnet wurden. Dabei wurde der Mehrteilchen-Hamilton-Operator in eine Basis aus antisymmetrisierten Produkten aus Einteilchenwellenfunktionen (Slater-Determinaten) entwickelt. Die Einteilchenzustände wurden mittels der so genannten 8-Band-k p-Theorie unter Berücksichtigung der realen 3D-Geometrie, der durch das Stranski-Krastanow Wachstumsverfahren bedingten Gitterverzerrung und der hier entscheidenden piezoelektrischen Effekte berechnet. Die aus der Quantenchemie abgeleitete CI-Methode ist sehr exakt und berücksichtigt neben den direkten Coulomb- und Korrelationseffekten auch die hier auftretenden Austauschterme. Mittels dieser Methode wurde erfinderseitig die Feinstrukturaufspaltung von auf (111)-Substrat platzierten Quantenpunkten modelliert, wobei die Quantenpunkte selbst als rotationssymmetrisch angenommen wurden. Variiert wurden das vertikale Aspektverhältnis (Verhältnis Höhe zu Breite), die Quantenpunktgröße und der mittlere Indiumanteil im Quantenpunkt. Aus Symmetrieüberlegungen konnte abgeleitet werden, dass für jeden Quantenpunkt auf einem (111)-Substrat mit einer mindestens dreizähligen Symmetrieachse senkrecht zur (111)-Ebene die Feinstrukturaufspaltung verschwinden muss. Dies deckt sich auch mit numerischen Simulationen, die erfinderseitig durchgeführt wurden. Erfinderseitig wurde dabei außerdem festgestellt, dass es aufgrund der Gittersymmetrie bei einer {111}-Kristalloberfläche keine orthogonal zueinander stehenden Anisotropierichtungen für die Ad-atom-Mobilitäten gibt, die zum Wachstum eines in lateraler Richtung elongierten Quantenpunkts führen könnte. Bei einer "perfekten" {111}-Oberfläche ist also stets mit einer C3v-Symmetrie des Quantenpunkts - d.h. der entstehende Quantenpunkt besitzt eine dreizählige Symmetrieachse - und damit mit einem Wegfall der Feinstrukturaufspaltung zu rechnen. Abweichungen davon sind ausschließlich statistischer (zufälliger) Natur und technisch zu vernachlässigen.

Ein weiterer wesentlicher Vorteil des erfindungsgemäßen Verfahrens besteht darin, dass ein durch Verspannung des Quantenpunkts entstehendes piezoelektrisches Feld für den Quantenpunkt keine symmetriereduzierende Wirkung entfaltet und somit die C3v-Symmetrie und damit die Feinstrukturaufspaltung auch im Falle einer Verspannung und bei Auftreten eines piezoelektrischen Felds erhalten bleibt.

Ein dritter wesentlicher Vorteil des erfindungsgemäßen Verfahrens beruht darauf, dass die Symmetrie des unterliegenden Kristallgitters des Halbleitersubstrats mit der C3v-Symmetrie des Quantenpunkts verträglich ist und demgemäß also keine symmetrieerniedrigende Wirkung entfalten kann. Aufgrund der Verwendung einer {111}-Substratfläche weist das quantenmechanische Confinement-Potential ebenfalls mindestens eine C3v-Symmetrie auf, so dass die Feinstrukturaufspaltung verschwinden muss und sich demgemäß verschränkte Photonenpaare erzeugen lassen.

Ein weiterer wesentlicher Vorteil des erfindungsgemäßen Verfahrens ist darin zu sehen, dass sich mit diesem in sehr einfacher Weise Photonenpaarquellen für eine Dateiverschlüsselung, welche auf quantenmechanischen Prinzipien basiert, herstellen lassen. Bei verschränkten Photonenpaaren beeinflusst die Messung eines Photons direkt das Messergebnis für das andere Photon des jeweiligen Photonenpaares, selbst wenn dieses weit entfernt ist. Ein potentieller "Mithörer" müsste, um an Informationen zu gelangen, ein eigenes Messgerät in die Übertragungsleitung stellen und würde damit zwangsläufig durch seine Messung die Verschränktheit der Photonenpaare aufheben, die Photonenübertragung also verändern. Dies wiederum macht sich in den Polarisationsmessungen am Ort des Empfängers bemerkbar, so dass ein Abhören bemerkt werden kann.

Gemäß einer bevorzugten Ausgestaltung des Verfahrens ist vorgesehen, dass das vertikale Aspektverhältnis des Quantenpunkts zwischen 0,05 und 0,7, insbesondere zwischen 0,15 und 0,5, liegt. Beispielsweise wird das Verhältnis zwischen der Höhe des Quantenpunkts und dem Durchmesser des Quantenpunkts - an der Auflagefläche auf dem Halbleitersubstrat - zwischen 0,05 und 0,7 eingestellt.

Der zumindest eine Quantenpunkt und/oder das Halbleitersubstrat bestehen vorzugsweise aus einem Mischkristall, der aufweist:

- In(Ga)As-Material, das in einen Ga(In,Al)As-Kristall eingebaut ist,
- In(Ga)P-Material, das in einen Ga(In,Al)P-Kristall eingebaut ist,
- In(Ga)As-Material, das in einen In(Ga,Al)P-Kristall eingebaut ist, und/oder
- $In_xGa_{1-x}As$-Material, wobei x zwischen 0,3 und 1 liegt.

Der Durchmesser des Quantenpunkts - an der Auflagefläche auf dem Halbleitersubstrat - wird vorzugsweise zwischen 5 nm und 50 nm, insbesondere zwischen 10 nm und 20 nm, gewählt.

Die Kontur des Quantenpunkts - senkrecht zur {111}-Fläche des Substrats gesehen - ist bevorzugt dreieckig, sechseckig oder rund.

Die Erfindung bezieht sich außerdem auf eine Photonenpaarquelle zum Erzeugen verschränkter Photonenpaare mit zumindest einem Quantenpunkt.

Erfindungsgemäß ist diesbezüglich vorgesehen, dass der zumindest eine Quantenpunkt auf einer {111}-Kristallfläche eines Halbleitersubstrats abgeschieden ist.

Bezüglich der Vorteile der erfindungsgemäßen Photonenpaarquelle sei auf die obigen Ausführungen im Zusammenhang mit dem erfindungsgemäßen Verfahren verwiesen, da die Vorteile der erfindungsgemäßen Photonenpaarquelle denen des erfindungsgemäßen Verfahrens im Wesentlichen entsprechen.

Vorteilhafte Ausgestaltungen der Photonenpaarquelle sind in Unteransprüchen angegeben.

Die Erfindung wird nachfolgend anhand von Ausführungsbeispielen näher erläutert; dabei zeigen beispielhaft

Fig. 1 ein schematisches Energiediagramm,

Fig. 2 einen Vergleich zwischen der Photonenstatistik verschiedener Photonenquellen,

Fig. 3 piezoelektrische Felder im Vergleich,

Fig. 4 eine (001)- und eine (111)-Substratorientierung,

Fig. 5 Bindungsenergien im Vergleich und

Fig. 6 ein Ausführungsbeispiel für eine erfindungsgemäße Photonenpaarquelle.

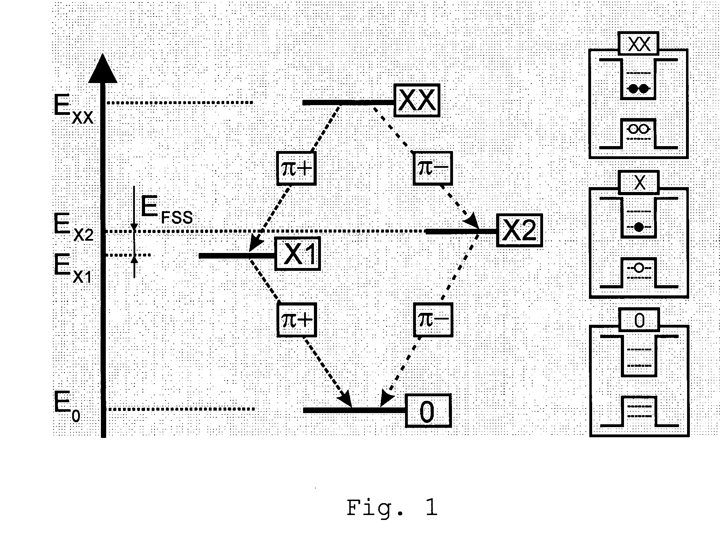

In der Figur 1 ist zur allgemeinen Erläuterung ein schematisches Energiediagramm für ein Exziton (X) und ein Biexziton (XX) in einem Quantenpunkt dargestellt. Man erkennt die Feinstrukturaufspaltung FSS des exzitonischen Zustandes, die sich zu $E_{X1}$ - $E_{X2}$ ergibt. Die beiden senkrecht aufeinander stehenden Polarisationsrichtungen sind mit den Bezugszeichen π+ und π- bezeichnet. Eine Emission verschränkter Photonenpaare lässt sich erreichen, wenn die Feinstrukturaufspaltung FSS möglich klein ist, also beispielsweise zwischen -100 μeV und +100 μeV liegt. Es werden hierzu Photonen aus der Biexziton → Exziton → 0 Zerfallskaskade verwendet. Ein zu großer energetischer Abstand zwischen den zwei vorhandenen exzitonischen Zuständen würde die Verschränktheit der emittierten Photonenpaare verhindern.

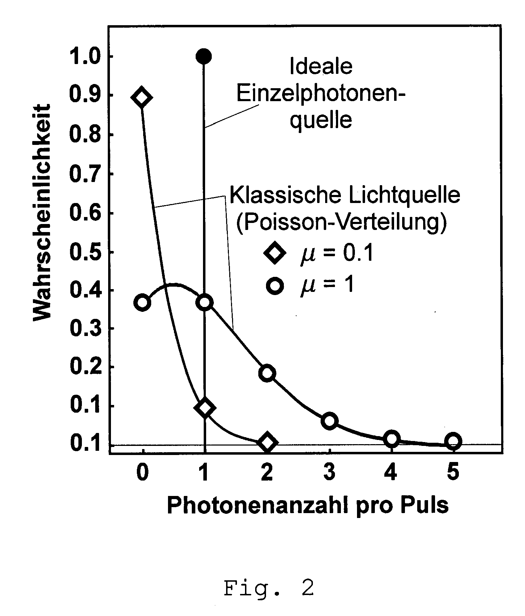

Die Figur 2 zeigt zur allgemeinen Erläuterung einen Vergleich zwischen der Photonenstatistik einer klassischen Photonenquelle, die nach der Poisson-Statistik $p(n) = \dfrac{\mu^n}{n!}e^{-\mu}$ Lichtquanten aussendet, und einer Einzelphotonenquelle, wie sie zum Beispiel mit Quantenpunkten realisiert sein kann. p(n) gibt die Wahrscheinlichkeit an, n Photonen in einem Puls zu finden; p bezeichnet die mittlere Anzahl von Photonen pro Puls. Diese Befunde lassen sich auf Photonenpaarquellen zum Erzeugen von Paaren verschränkter Photonen übertragen.

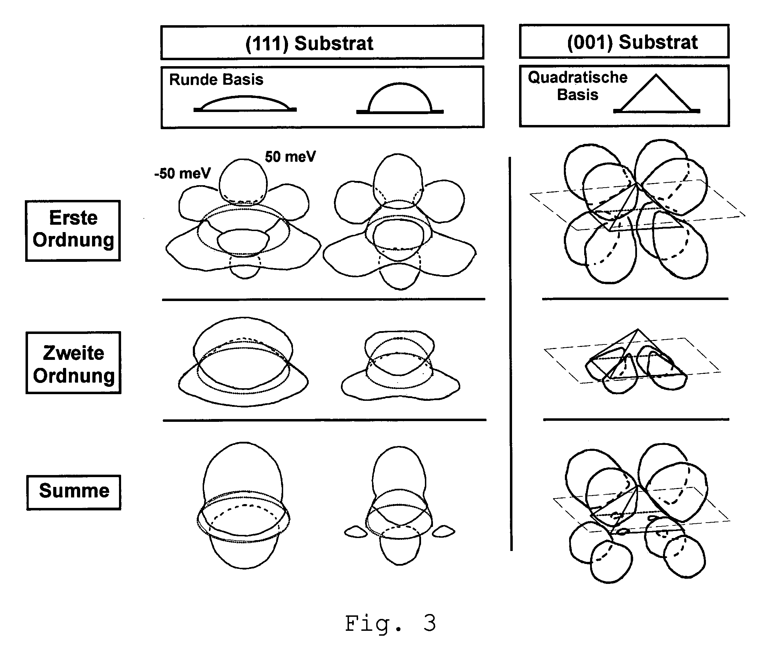

Die Figur 3 zeigt einen Vergleich der piezoelektrischen Felder (1. und 2. Ordnung) von Quantenpunkten, die auf einer (111)-Fläche (links) und auf einer (001)-Fläche (rechts) platziert wurden. Man erkennt die unterschiedliche Ausgestaltung der piezoelektrischen Felder, die dazu führt, dass bei einem Wachstum eines Quantenpunkts auf einer (111)-Fläche die Feinstrukturaufspaltung stets Null beträgt, und die auch dazu führt, dass sich bei einem Wachstum auf einer (001)-Fläche eine Feinstrukturaufspaltung von Null nur sehr schwer erreichen lässt.

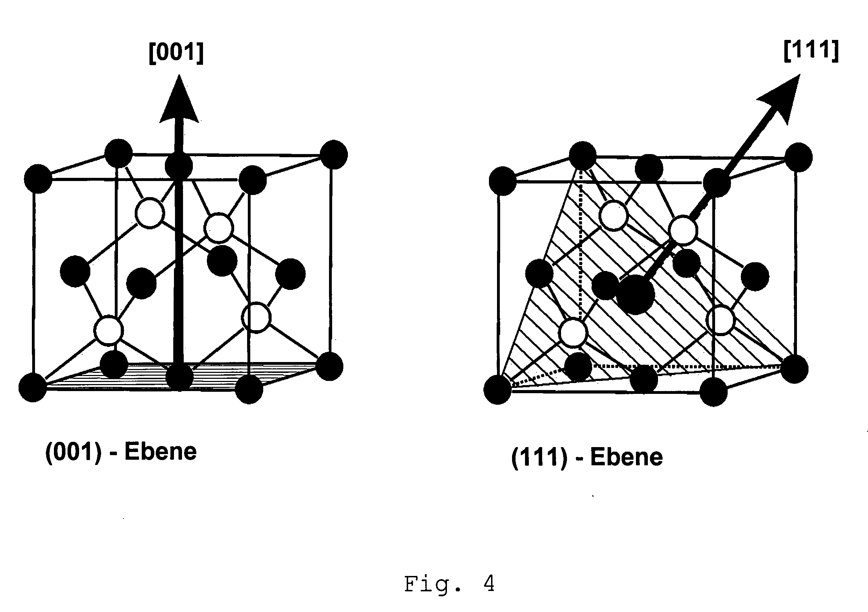

In der Figur 4 sind zur allgemeinen Erläuterung die (001)-und die (111)-Kristallorientierung nochmals in einer dreidimensionalen Darstellung gezeigt.

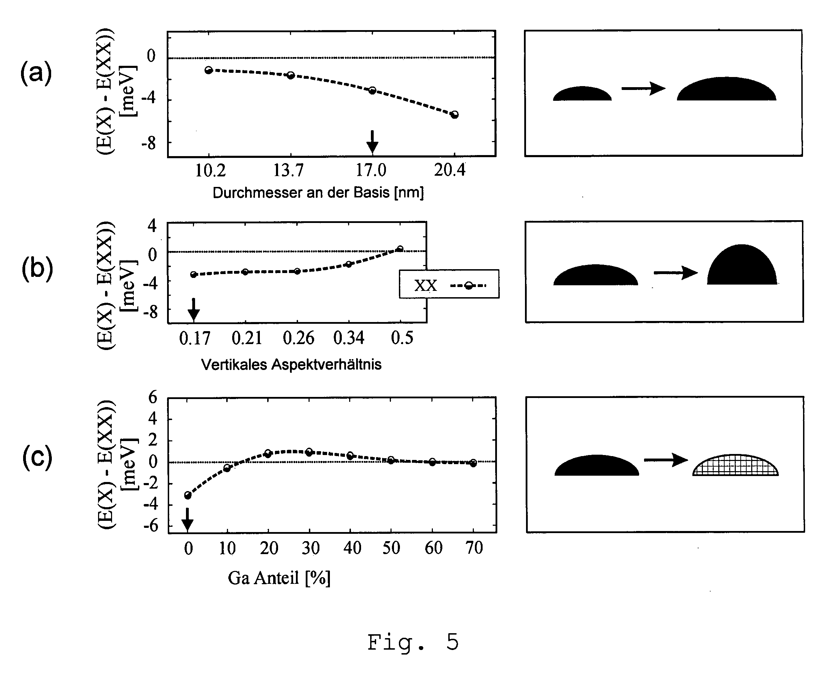

In der Figur 5 sind für Ausführungsbeispiele von Photonenpaarquellen die Bindungsenergien des Biexzitons (gestrichelte, gekrümmte Linie) relativ zum Exziton (auf 0 gesetzt, durchgehende Linie bei 0 meV) gezeigt. Man erkennt, dass sich die Differenz zwischen der Biexzitonübergangsenergie und der Exzitonübergangsenergie, also die Biexzitonbindungsenergie, bei konstanter Feinstrukturaufspaltung gleich Null durch geeignete Parameterwahl der Quantenpunkte beeinflussen lässt. Die Fig. 5 zeigt die Bindungsenergien für folgende Fälle:

(a) Für den Fall der Variation der Quantenpunktgröße, von 10,2 nm bis 20,4 nm Durchmesser. Das vertikale Aspektverhältnis beträgt 0,17.
(b) Für den Fall der Variation des vertikalen Aspektverhältnisses zwischen 0,17 und 0,5 bei konstantem Volumen. Der Durchmesser der flachsten Struktur beträgt hier beispielsweise 17,0 nm.
(c) Für den Fall der Variation des Gehaltes von InAs im Quantenpunkt zwischen 100% (0% GaAs) und 30% (70% GaAs). Diejenige Quantenpunktstruktur, die in allen drei Serien gemeinsam auftaucht, ist jeweils mit einem Pfeil gekennzeichnet.

Die Quantenpunktgröße, das vertikale Aspektverhältnis und die chemische Komposition des Systems werden vorzugsweise als Parameter verwendet, um optimale Eigenschaften der Photonenpaarquellen nach den jeweiligen Einsatzanforderungen zu erreichen. Folgende Parameter, einzeln oder in Kombination, sind als vorteilhaft anzusehen:

- Das vertikale Aspektverhältnis der Quantenpunkte liegt zwischen 0,05 und 0,7, insbesondere zwischen 0,15 und 0,5.
- Das Verhältnis zwischen der Höhe der Quantenpunkte und dem Durchmesser der Quantenpunkte liegt zwischen 0,05 und 0,7.
- Der Durchmesser der Quantenpunkte liegt zwischen 5 nm und 50 nm, insbesondere zwischen 10 nm und 20 nm.
- Die Quantenpunkte weisen eine dreieckige, sechseckige oder runde Kontur auf.
- Das Substrat und/oder die Quantenpunkte bestehen aus einem Mischkristall, der aufweist:

  - In(Ga)As-Material, das in einen Ga(In,Al)As-Kristall eingebaut ist, und/oder
  - In(Ga)P-Material, das in einen Ga(In,Al)P-Kristall eingebaut ist, und/oder
  - In(Ga)As-Material, das in einen In(Ga,Al)P-Kristall eingebaut ist, und/oder
  - $In_xGa_{1-x}As$-Material, wobei x zwischen 0,3 und 1 liegt.

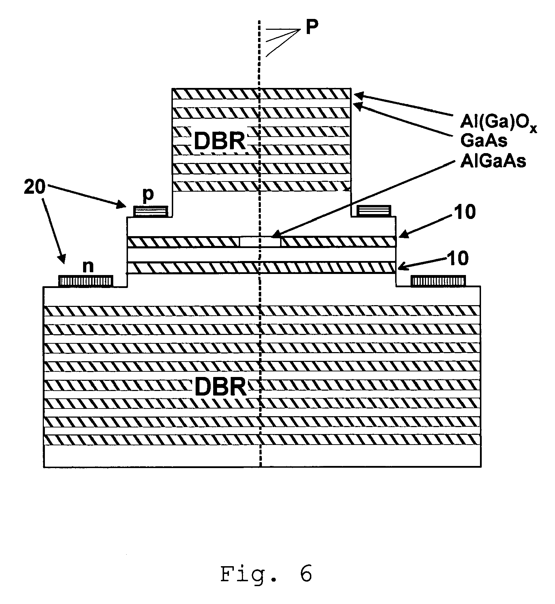

Die Figur 6 zeigt ein Ausführungsbeispiel für eine Photonenpaarquelle in einer dreidimensionalen Sicht. Man erkennt, wie die Quantenpunktschicht in eine Kavität eingebettet ist. Am oberen sowie am unteren Ende befinden sich DBR-Spiegel DBR (DBR: Distributed Bragg Reflector = verteilter Bragg-Reflektor). Die Oxidapertur 10 dient zur Manipulation des Strompfades und damit der zielgerichteten räumlichen Selektion von einzelnen Quantenpunkten.

Die Einbettung in eine Kavität ermöglicht es, die entstehenden Photonenpaare P gerichtet und effizient aus der Photonenpaarquelle auszukoppeln. Ähnlich wie bei vertikal emittierenden Lasern ist die Kavität vorzugsweise so ausgestaltet, dass die Energie der verschränkten Photonen in Resonanz mit den Kavitätsmoden ist. Basierend auf dem Purcell-Effekt wird damit die Rate der spontanen Emission hinaufgesetzt und zudem die Auskopplungseffizienz erhöht. Die Metallkontakte sind mit dem Bezugszeichen 20 gekennzeichnet.

Eine solche Photonenpaarquelle könnte beispielsweise einen Bestandteil eines photonischen Netzes zur Übermittlung quantenkryptographisch verschlüsselter Daten bilden, z.B. mittels des Eckert-Protokolls (A. Eckert, J. Rarity, P. Tapster, M. Palma, Phys. Rev. Lett.69, S.1293 ff (1992)).

**Patentansprüche**

1. Verfahren zum Herstellen einer verschränkte Photonenpaare erzeugenden Photonenpaarquelle mit mindestens einem Quantenpunkt, wobei bei dem Verfahren das Betriebsverhalten der Photonenpaarquelle durch ein Einstellen der Feinstrukturaufspaltung des exzitonischen Energieniveaus des zumindest einen Quantenpunkts festgelegt wird,
   **dadurch gekennzeichnet, dass**
   das Einstellen der Feinstrukturaufspaltung des exzitonischen Energieniveaus dadurch erfolgt, dass der zumindest eine Quantenpunkt auf einer {111}-Kristallfläche eines Halbleitersubstrats abgeschieden wird.

2. Verfahren nach Anspruch 1,
   **dadurch gekennzeichnet, dass**
   ein vertikales Aspektverhältnis des Quantenpunkts zwischen 0,05 und 0,7, insbesondere zwischen 0,15 und 0,5, hergestellt wird.

3. Verfahren nach einem der vorangehenden Ansprüche,
   **dadurch gekennzeichnet, dass**
   das Verhältnis zwischen der Höhe des Quantenpunkts und dem Durchmesser des Quantenpunkts - an der Auflagefläche auf dem Halbleitersubstrat - zwischen 0,05 und 0,7 eingestellt wird.

4. Verfahren nach einem der vorangehenden Ansprüche 1-3,
   **dadurch gekennzeichnet, dass**

der zumindest eine Quantenpunkt aus einem Mischkristall hergestellt wird, wobei der Mischkristall In(Ga)As-Material aufweist, das in einen Ga(In,Al)As-Kristall eingebaut ist.

5. Verfahren nach einem der vorangehenden Ansprüche 1-3,
**dadurch gekennzeichnet, dass**
der zumindest eine Quantenpunkt aus einem Mischkristall hergestellt wird, wobei der Mischkristall In(Ga)P-Material aufweist, das in einen Ga(In,Al)P-Kristall eingebaut ist.

6. Verfahren nach einem der vorangehenden Ansprüche 1-3,
**dadurch gekennzeichnet, dass**
der zumindest eine Quantenpunkt aus einem Mischkristall hergestellt wird, wobei der Mischkristall In(Ga)As-Material aufweist, das in einen In(Ga,Al)P-Kristall eingebaut ist.

7. Verfahren nach einem der vorangehenden Ansprüche 1-3,
**dadurch gekennzeichnet, dass**
der zumindest eine Quantenpunkt aus einem Misch-kristall mit $In_xGa_{1-x}$As-Material, wobei x zwischen 0,3 und 1 liegt, hergestellt wird.

8. Verfahren nach einem der vorangehenden Ansprüche,
**dadurch gekennzeichnet, dass**
der Quantenpunkt mit einem Durchmesser - an der Auflagefläche auf dem Halbleitersubstrat - zwischen 5 nm und 50 nm, insbesondere zwischen 10 nm und 20 nm, hergestellt wird.

9. Verfahren nach einem der vorangehenden Ansprüche,
**dadurch gekennzeichnet, dass**
der Quantenpunkt mit einer dreieckigen, sechseckigen oder runden Kontur, insbesondere senkrecht zur {111}-Fläche des Substrats gesehen, hergestellt wird.

10. Photonenpaarquelle zum Erzeugen verschränkter Photonenpaare mit zumindest einem Quantenpunkt,
**dadurch gekennzeichnet, dass**
der zumindest eine Quantenpunkt auf einer {111}-Kristallfläche eines Halbleitersubstrats abgeschieden ist.

11. Photonenpaarquelle nach Anspruch 10,
**dadurch gekennzeichnet, dass**
das Verhältnis zwischen der Höhe des Quantenpunkts und dem Durchmesser des Quantenpunkts - an der Auflagefläche auf der {111}-Kristallfläche des Halbleitersubstrats - zwischen 0,05 und 0,7, insbesondere zwischen 0,15 und 0,5, liegt.

12. Photonenpaarquelle nach einem der vorangehenden Ansprüche 10-11,
**dadurch gekennzeichnet, dass**
der zumindest eine Quantenpunkt und/oder das Halbleitersubstrat aus einem Mischkristall besteht, der aufweist:

- In(Ga)As-Material, das in einen Ga(In,Al)As-Kristall eingebaut ist, und/oder
- In(Ga)P-Material, das in einen Ga(In,Al)P-Kristall eingebaut ist, und/oder
- In(Ga)As-Material, das in einen In(Ga,Al)P-Kristall eingebaut ist, und/oder
- $In_xGa_{1-x}$As-Material, wobei x zwischen 0,3 und 1 liegt.

13. Photonenpaarquelle nach einem der vorangehenden Ansprüche 10-12,
**dadurch gekennzeichnet, dass**
der Durchmesser des Quantenpunkts - an der Auflagefläche auf der {111}-Kristallfläche des Halbleitersubstrats - zwischen 5 nm und 50 nm, insbesondere zwischen 10 nm und 20 nm, beträgt.

14. Photonenpaarquelle nach einem der vorangehenden Ansprüche 10-13,
**dadurch gekennzeichnet, dass**
der Quantenpunkt eine dreieckige, sechseckige oder runde Kontur, insbesondere senkrecht zur {111}-Fläche des Halbleitersubstrats gesehen, aufweist.

**Claims**

1. Method for producing a photon pair source, which generates entangled photon pairs, comprising at least one quantum dot, wherein, in the method, the operational behavior of the photon pair source is defined by setting the fine structure splitting of the excitonic energy level of the at least one quantum dot,
**characterized in that**
the fine structure splitting of the excitonic energy level is set by the at least one quantum dot being deposited on a {111} crystal face of a semiconductor substrate.

2. Method according to Claim 1,
**characterized in that**
a vertical aspect ratio of the quantum dot of between 0.05 and 0.7, in particular between 0.15 and 0.5, is produced.

3. Method according to either of the preceding claims,
**characterized in that**
the ratio between the height of the quantum dot and the diameter of the quantum dot - at the bearing area on the semiconductor substrate - is set to be between 0.05 and 0.7.

4. Method according to any of the preceding Claims 1-3,
**characterized in that**
the at least one quantum dot is produced from a mixed crystal, wherein the mixed crystal comprises In(Ga)As material incorporated into a Ga(In,Al)As crystal.

5. Method according to any of the preceding Claims 1-3,
**characterized in that**
the at least one quantum dot is produced from a mixed crystal, wherein the mixed crystal comprises In(Ga)P material incorporated into a Ga(In,Al)P crystal.

6. Method according to any of the preceding Claims 1-3,
**characterized in that**
the at least one quantum dot is produced from a mixed crystal, wherein the mixed crystal comprises In(Ga)As material incorporated into an In(Ga,Al)P crystal.

7. Method according to any of the preceding Claims 1-3,
**characterized in that**
the at least one quantum dot is produced from a mixed crystal comprising $In_xGa_{1-x}As$ material, where x is between 0.3 and 1.

8. Method according to any of the preceding claims,
**characterized in that**
the quantum dot is produced with a diameter - at the bearing area on the semiconductor substrate - of between 5 nm and 50 nm, in particular between 10 nm and 20 nm.

9. Method according to any of the preceding claims,
**characterized in that**
the quantum dot is produced with a triangular, hexagonal or round contour, in particular as viewed perpendicularly to the {111} face of the substrate.

10. Photon pair source for generating entangled photon pairs comprising at least one quantum dot,
**characterized in that**
the at least one quantum dot is deposited on a {111} crystal face of a semiconductor substrate.

11. Photon pair source according to Claim 10,
**characterized in that**
the ratio between the height of the quantum dot and the diameter of the quantum dot - at the bearing area on the {111} crystal face of the semiconductor substrate - is between 0.05 and 0.7, in particular between 0.15 and 0.5.

12. Photon pair source according to either of the preceding Claims 10-11,
**characterized in that**
the at least one quantum dot and/or the semiconductor substrate consists of a mixed crystal comprising:

- In(Ga)As material incorporated into a Ga(In,Al)As crystal, and/or
- In(Ga)P material incorporated into a Ga(In,Al)P crystal, and/or
- In(Ga)As material incorporated into an In(Ga,Al)P crystal, and/or
- $In_xGa_{1-x}As$ material, where x is between 0.3 and 1.

13. Photon pair source according to any of the preceding Claims 10-12,
**characterized in that**
the diameter of the quantum dot - at the bearing area on the {111} crystal face of the semiconductor substrate - is between 5 nm and 50 nm, in particular between 10 nm and 20 nm.

14. Photon pair source according to any of the preceding Claims 10-13,
**characterized in that**
the quantum dot has a triangular, hexagonal or round contour, in particular as viewed perpendicularly to the {111} face of the semiconductor substrate.

**Revendications**

1. Procédé de fabrication d'une source de paires de photons produisant des paires de photons intriqués, comportant au moins un point quantique, dans lequel, dans le procédé, le comportement de la source de paires de photons est défini par un ajustement du dédoublement de la structure fine du niveau d'énergie excitonique du ou des points quantiques, **caractérisé en ce que** l'ajustement du dédoublement de la structure fine du niveau d'énergie excitonique est réalisé par dépôt du ou des points quantiques sur une surface cristalline {111} d'un substrat semi-conducteur.

2. Procédé selon la revendication 1, **caractérisé en ce qu'**on réalise un rapport d'aspect vertical du point quantique compris entre 0,05 et 0,7, en particulier entre 0,15 et 0,5.

3. Procédé selon l'une des revendications précédentes, **caractérisé en ce que** le rapport entre la hauteur du point quantique et le diamètre du point quantique - sur la surface d'appui sur le substrat semi-conducteur - est ajusté à une valeur comprise entre 0,05 et 0,7.

4. Procédé selon l'une des revendications précédentes 1 à 3, **caractérisé en ce que** le ou les points quantiques sont fabriqués à partir d'un cristal mixte, le cristal mixte comportant un matériau In(Ga)As, qui est incorporé dans un cristal de Ga(In,Al)As.

5. Procédé selon l'une des revendications précédentes 1 à 3, **caractérisé en ce que** le ou les points quantiques sont fabriqués à partir d'un cristal mixte, le cristal mixte comprenant un matériau In(Ga)P, qui est incorporé dans un cristal de Ga(In,Al)P.

6. Procédé selon l'une des revendications 1 à 3, **caractérisé en ce que** le ou les points quantiques sont fabriqués à partir d'un cristal mixte, le cristal mixte comprenant un matériau In(Ga)As, qui est incorporé dans un cristal d'In(Ga,Al)P.

7. Procédé selon l'une des revendications précédentes 1 à 3, **caractérisé en ce que** le ou les points quantiques sont fabriqués à partir d'un cristal mixte comprenant un matériau $In_xGa_{1-x}As$, où x est compris entre 0,3 et 1.

8. Procédé selon l'une des revendications précédentes, **caractérisé en ce que** le point quantique est fabriqué avec un diamètre - sur la surface d'appui sur le substrat semi-conducteur - compris entre 5 nm et 50 nm, en particulier entre 10 nm et 20 nm.

9. Procédé selon l'une des revendications précédentes, **caractérisé en ce que** le point quantique est fabriqué avec un contour triangulaire, hexagonal ou circulaire, en particulier quand on l'observe perpendiculairement à la surface {111} du substrat.

10. Source de paires de photons pour produire des paires de photons intriqués, comprenant au moins un point quantique, **caractérisée en ce que** le ou les points quantiques sont déposés sur une surface cristalline {111} d'un substrat semi-conducteur.

11. Source de paires de photons selon la revendication 10, **caractérisée en ce que** le rapport entre la hauteur du point quantique et le diamètre du point quantique - sur la surface d'appui sur la surface cristalline {111} du substrat semi-conducteur - est compris entre 0,05 et 0,7, en particulier entre 0,15 et 0,5.

12. Source de paires de photons selon l'une des revendications précédentes 10 à 11, **caractérisée en ce que** le ou les points quantiques, et/ou le substrat semi-conducteur, sont constitués d'un cristal mixte qui comprend :

- un matériau In(Ga)As qui est incorporé dans un cristal de Ga(In,Al)As, et/ou
- un matériau In(Ga)P qui est incorporé dans un cristal de Ga(In,Al)P, et/ou
- un matériau In(Ga)As qui est incorporé dans un cristal d'In(Ga,Al)P, et/ou
- un matériau $In_xGa_{1-x}As$, où x est compris entre 0,3 et 1.

13. Source de paires de photons selon l'une des revendications 10 à 12, **caractérisée en ce que** le diamètre du point quantique - sur la surface d'appui sur la surface cristalline {111} du substrat semi-conducteur - est compris entre 5 nm et 50 nm, en particulier entre 10 nm et 20 nm.

14. Source de paires de photons selon l'une des revendications précédentes 10 à 13, **caractérisée en ce que** le point quantique présente un contour triangulaire, hexagonal ou circulaire, en particulier quand on l'on observe perpendiculairement à la surface {111} du substrat semi-conducteur.

Fig. 1

EP 2 308 143 B1

Fig. 2

Fig. 3

[111]

(111) - Ebene

[001]

(001) - Ebene

Fig. 4

Fig. 5

Fig. 6

## IN DER BESCHREIBUNG AUFGEFÜHRTE DOKUMENTE

**In der Beschreibung aufgeführte Patentdokumente**

- WO 2007062625 A2

**In der Beschreibung aufgeführte Nicht-Patentliteratur**

- **P. GALLO.** Integration of site-controlled pyramidal quantum dots and photonic crystal membrane cavities. *Applied Physics Letters,* 2008, vol. 92, 263101

- **R.M.STEVENSON.** A semiconductor source of triggered entangled photon pairs. *Nature,* 12. Januar 2006, vol. 439, 179-182
- **A. ECKERT ; J. RARITY ; P. TAPSTER ; M. PALMA.** *Phys. Rev. Lett.,* 1992, vol. 69, 1293 ff